# EUROPÄISCHE PATENTSCHRIFT

(11) **EP 0 985 226 B1**
(45) Veröffentlichungstag und Bekanntmachung des Hinweises auf die Patenterteilung: **10.09.2008**
(21) Anmeldenummer: 98928076.3
(22) Anmeldetag: 26.03.1998
(51) Int. Cl.: H01L 21/58, H01L 23/24

(54) **VERFAHREN ZUR HERSTELLUNG ELEKTRISCHER BAUGRUPPEN**
METHOD FOR MANUFACTURING ELECTRIC MODULES
PROCEDE DE FABRICATION DE MODULES ELECTRIQUES

(30) Priorität: 28.05.1997 DE 19722355
(43) Veröffentlichungstag der Anmeldung: 15.03.2000
(73) Patentinhaber: ROBERT BOSCH GMBH, 70442 Stuttgart (DE)
(72) Erfinder: JAHN, Hans-Peter, D-72124 Pliezhausen (DE); ERNST, Stephan, D-70374 Stuttgart (DE); BRIELMANN, Volker, D-71332 Waiblingen (DE)
(86) Internationale Anmeldenummer: PCT/DE1998/000883
(87) Internationale Veröffentlichungsnummer: WO 1998/054760

(56) Entgegenhaltungen:
- EP-A- 0 575 889
- EP-A- 0 701 278
- DE-A- 3 517 965
- DE-A- 3 939 628
- DE-A- 19 637 285
- JP-A- 60 136 348
- PATENT ABSTRACTS OF JAPAN vol. 014, no. 067 (E-0885), 7. Februar 1990 & JP 01 286453 A (HITACHI LTD;OTHERS: 01), 17. November 1989

## Beschreibung

### Stand der Technik

Die Erfindung geht aus von einem Verfahren nach der Gattung der unabhängigen Ansprüche. Aus der DE 3939628 ist schon ein solches Verfahren bzw. eine solche elektrische Baugruppe bekannt, bei dem bzw. bei der Bauelemente mit einem UV-härtbaren Klebstoff oder Klebharz (kurz: "Klebstoff") auf keramische Schichtschaltungen geklebt werden und die Aushärtung des Klebstoffes durch rückseitig Bestrahlung der keramischen Schichtschaltungen mit UV-Licht erfolgt. Dabei wird durch den durch das Substrat hindurchtretenden Anteil des-UV-Lichts die Härtung des Klebstoffes unter dem gesamten Bauelement bewirkt.

Aus der Schrift JP 60 13 63 48 ist ein Halbleiterbauelement bekannt, welches mittels eines Klebstoffs auf einer Wärmesenke 4 befestigt ist. Das Halbleiterbauelement ist dabei von einem Gel umgeben, welches seinerseits von einer Kappe umgeben ist.

Weiterhin aus der Schrift EP 07 01 278 A2 eine Befestigung eines Halbleiterchips auf einem Substrat mittels eines Klebstoffs bekannt. Die Versiegelung des Halbleiterchips auf dem Substrat erfolgt dabei bei einer Temperatur von 150° Celsius, bei dem der Klebstoff ausgehärtet wird.

Aus der Schrift DE 39 39 628 A1 ist ein Verfahren bekannt, bei dem ein Bauelement mit einem UV-härtbaren Klebstoff auf eine keramische Schichtschaltung geklebt wird. Die Aushärtung des Klebstoffs erfolgt dabei durch rückseitige Bestrahlung der keramischen Schichtschaltung mit UV-Licht. Dabei wird durch den durch das Substrat hindurchtretenden Anteil des UV-Lichts die Härtung des Klebstoffs unter dem gesamten Bauelement bewirkt.

### Vorteile der Erfindung

Das erfindungsgemäße Verfahren mit den Merkmalen des unabhängigen Verfahrensanspruchs hat demgegenüber den Vorteil, daß nach der Vorhärtung des Klebstoffs in einem weiteren Schritt das Leistungsbaustein mit einem Gel umhüllt wird, wobei nach dem Vergelungsprozeß das Gel und der Klebstoff zusammen in einem Schritt in einem Ofenprozeß ausgehärtet werden können. Das bedeutet eine erhebliche Zeitersparnis gegenüber zwei getrennten Ofenprozessen für den Klebstoff und das Gel. Als Vortei ist anzusehen, daß eine kompakte Bauweise gegeben ist, die eine betriebssichere Kontaktierung und Kühlung der auf dem Leistungsbaustein angeordneten Bauelemente gewährleistet.

Durch die in den abhängigen Ansprüchen aufgeführten Maßnahmen sind vorteilhafte Weiterbildungen und Verbesserungen der in den unabhängigen Ansprüchen angegebenen Verfahren. möglich. Besonders vorteilhaft ist die Randanhärtung des Klebstoffes in einem Randbereich des Leistungsbausteins mit UV-Bestrahlung. Dadurch ist nur ein kleiner, frei zugänglicher Bereich für die aushärtende Strahlung notwendig, und der Vorhärteprozeß mit UV-Licht benötigt nur wenige Sekunden. Führt also gegenüber einer Aushärtung in einem Ofenprozeß zu einer außerordentlichen Zeitersparnis.

Als außerordentlich vorteilhaft erweist sich die Vorhärtung des Klebstoffs in Verbindung mit einem Bondprozeß des Leistungsbausteins. Durch die Vorhärtung ist eine ausreichende Anbindung des Leistungsbausteins an ein Befestigungsteil gegeben, um in einem automatisierten Bondprozeß eine fehlerfreie Kontaktierung des Leistungsbausteines zu ermöglichen. Das heißt, durch die Vorhärtung wird sowohl eine ausreichende Fixierung des Leistungsbausteines für das sogenannte Drahtbonden gewährleistet, als auch erheblich Zeit eingespart im Prozeß der Aushärtung des Klebstoffs und des für die Umhüllung des Leistungsbausteins verwendeten Gels.

Die Bereitstellung des Leistungsbausteins erfolgt in vorteilhafter Weise unter Einsatz eines metallischen Leiterrahmens, insbesondere aus Kupfer, auf dem Chips in beispielsweise elektrisch leitender Verbindung mit einem elektrisch leitfähigen Klebstoff aufgebracht werden. Auch hier kann bei der Aushärtung des Klebstoffs ein sonst üblicher und im Masseneinsatz umständlicher wie zeitaufwendiger Ofenprozeß entfallen, wenn auch hier der elektrisch leitende Klebstoff, der seitlich am Chip austritt, mit UV-Strahlung gehärtet wird oder wenn die Erhitzung des Klebstoffs zur Aushärtung zur Herstellung einer elektrischen Verbindung zwischen Leistungsbaustein und metallischem Block in einem Induktionsofen erfolgt, also in einem Ofen, in dem durch magnetische Induktion induzierte Wirbelströme eine geeignete Erhitzung bewirken.

Weitere vorteilhafte Weiterbildungen ergeben sich durch die in den übrigen Ansprüchen genannten Merkmale.

### Zeichnung

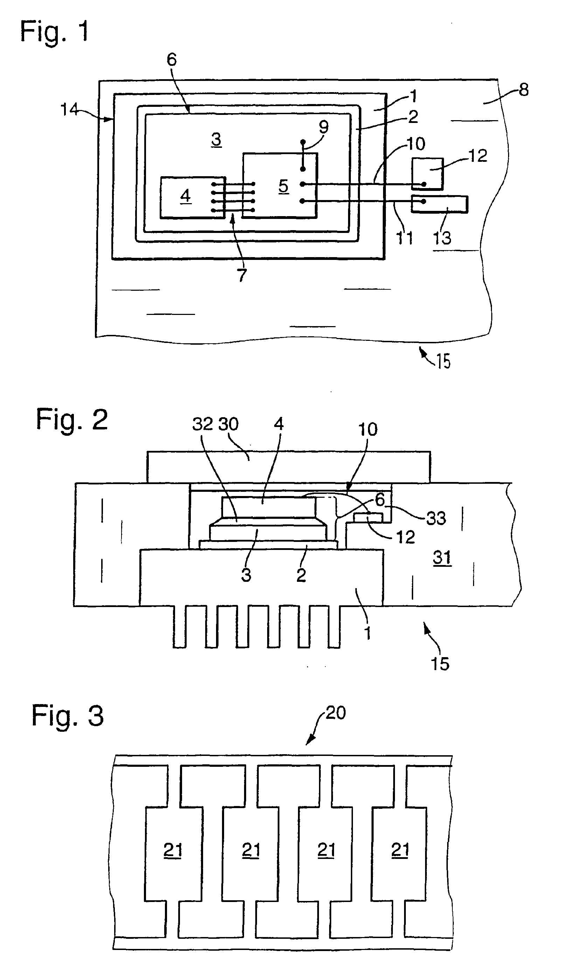

Ausführungsbeispiele der Erfindung sind in der Zeichnung dargestellt und in der nachfolgenden Beschreibung näher erläutert. Es zeigen Figur 1 eine Draufsicht auf eine nach dem erfindungsgemäßen Verfahren hergestellte elektrische Baugruppe, Figur 2 eine Querschnittsseitenansicht der elektrischen Baugruppe nach Figur 1 und Figur 3 den Aufbau eines im erfindungsgemäßen Verfahren verwendeten Leiterrahmens.

### Beschreibung der Ausführungsbeispiele

Figur 1 zeigt einen auf einem als Kühlkörper ausgebildeten Befestigungsteil 1 angeordneten Leistungsbaustein 6. Der Leistungsbaustein 6 weist ein als Kupferblock 3 ausgebildetes Bodenstück auf, auf dem ein Chip 4 und ein weiterer Chip 5 angeordnet sind. Die beiden Chips sind über Drahtbonds 7 elektrisch miteinander verbunden. Der Kühlkörper 1 ist mit einem Kunststoffgehäuse 8 verbunden, von dem ein Ausschnitt in der Figur 1 dargestellt ist. In der Vertiefung 14 der elektrischen Baugruppe 15 ist noch ein schmaler Rand des Kühlkörpers 1 ersichtlich. Der zwischen dem Kupferblock 3 und dem Kühlkörper 1 angeordnete Klebstoff schaut etwas unter dem Kupferblock 3 hervor, daß heißt, der Kupferblock 3 ist einem schmalen Randbereich von einem Randbereich der Klebstoffschicht 2 umgeben. Die Chips können beispielsweise über Drahtbonds 9 mit der vernickelten Oberfläche des Kupferblocks 3 in elektrischer Verbindung stehen, ebenso ist im gezeigten Ausführungsbeispiel der Chip 5 über Drahtbonds 10 und 11 mit Kontaktierflächen 12 und 13 elektrisch verbunden, wobei diese Kontaktierflächen im Kunststoffgehäuse angeordnet sind und entweder innerhalb des Kunststoffgehäuses oder auf dessen Oberfläche zu Kontaktierstellen der elektrischen Baugruppe geführt werden können, beispielsweise zu Löchern, die gleichzeitig zur mechanischen Fixierung der elektrischen Bautruppe dienen.

Figur 2 zeigt eine Seitenansicht der in der Figur 1 gezeigten elektrischen Baugruppe im Querschnitt. Gleiche Bezugszeichen wie in Figur 1 bezeichnen gleiche Teile und werden nicht nochmals beschrieben. Der Kühlkörper ist im gezeigten Ausführungsbeispiel ist rückseitig mit Kühlrippen versehen, während auf der Vorderseite des Kühlkörpers der auf dem Kühlkörper angeordnete Leistungsbaustein zum Zwecke des Korrosionsschutzes mit einem Gel 33 umgeben ist. Dieses Gel umgibt beispielweise auch die Kontaktierflächen 12. Das Kunststoffgehäuse 31 umgibt die Anordnung von Kühlkörper und Leistungsbaustein, wobei der Kühlkörper 1 in formschlüssiger Weise mit dem Kunststoffgehäuse 31 verbunden ist. Im gezeigten Querschnitt ist die beispielsweise elektrisch leitende Verbindung des Chips 4 mit dem Kupferblock 3 über einen elektrisch leitfähigen weiteren Klebstoff 32 ersichtlich. Die elektrische Baugruppe 15 ist ferner mit einem Deckel 30 versehen, der den mit einem Gel versehenen Bereich um den Leistungsbaustein herum beispielsweise vor mechanischen Schädigungen schützt.

Die elektrische Baugruppe 15 dient beispielsweise zur von einem Ladezustand einer Autobatterie abhängigen Aufladung dieser Batterie durch einen von einem Kfz-Motor angetriebenen Generator. Die Baugruppe ist dabei feindlichen Umwelteinflüssen eingesetzt und produziert hohe Verlustleistungen, so daß sowohl ein sicherer mechanischer Schutz als auch Korrosionsschutz sowie eine gute Ableitung der Verlustleistung gegeben sein muß, und dies bei möglichst kompakter Bauweise. Der Kühlkörper und die gut wärmeleitende Verbindung über den Kupferblock 3 und den gut wärmeleitfähigen Klebstoff 2 gewährleisten eine sichere Abfuhr der Verlustleistung, das um den Leistungsbaustein angeordnete Gel schützt vor Korrosion und der Deckel sowie das Kunststoffgehäuse 31 samt Kontaktierstellen gewährleisten Schutz vor mechanischer Schädigung sowie eine robuste mechanische und elektrische Anbindung der Baugruppe an andere Vorrichtungen.

Ein Verfahren zur Herstellung einer elektrischer Baugruppe nach Figur 1 und 2 wird im folgenden beschrieben: Zunächst wird ein Leiterrahmen 20 gemäß Figur 3 bereitgestellt, der vorzugsweise aus Kupfer besteht und Kupferblöcke 21 aufweist, die später jeweils das Bodenstück teil 3 eines Leistungsbausteines 6 bilden. Es wird ein elektrisch leitfähiger Klebstoff zur Herstellung einer elektrisch leitenden Verbindung (Massenverbindung) zwischen Chip und Kupferblock auf die Kupferblöcke 21 des Leiterrahmens 20 gestempelt. In einem weiteren Schritt werden die Chips auf den mit elektrisch leitfähigen Klebstoff versehenen Flächen angeordnet und der Klebstoff ausgehärtet. Dies geschieht in einem Ofenprozeß und dauert ca. 2 ½ Stunden. Wahlweise kann zur mechanischen Fixierung und elektrischen Kontaktierung der Chips auf den Kupferblöcken zwischen den Chips und den Kupferblökken ein Lot eingebracht werden, das im Ofenprozeß schmilzt und somit eine elektrische Verbindung zwischen Chip und Kupferblock herstellt. In einer vorteilhaften Ausführungsform der Erfindung wird das Vorhandensein eines metallischen Klebepartners, nämlich den Kupferblöcken sowie des elektrisch leitfähigen Klebstoffs, der Metallpartikel enthält, ausgenutzt, um statt eines aufwendigen Ofenprozesses (Zeit- und Platzaufwand) die Aushärtung des Klebstoffes (bzw. das Schmelzen des zwischen den Chips und den Kupferblöcken angeordneten Lots) über magnetische Induktion in einem Induktionsofen zu erzielen. Alternativ kann auch hier die Fixierung der Chips durch UV-Randanhärtung eines seitlich austretenden Leitklebstoffs erfolgen. Voraussetzung ist die Verwendung eines UV-härtbaren Leitklebstoffs. Die vollständige Aushärtung des UV-härtbaren elektrisch leitenden Klebstoffs erfolgt in einem weiteren Schritt zusammen mit dem Vergußgel. Die bisher beschriebenen Verfahrensschritte gehören zur Vormontage der Leistungsbausteine. Dabei können neben ganzen Chips auch einzelne Transistoren, Dioden, Zünder- oder Reglerchips auf einer Wärmersenke, insbesondere einem metallischen Kühlkörper, montiert werden. Die Klebstoffapplikation auf dem Leiterrahmen kann dabei durch Stempeln, Dispensen, Sieb- bzw. Schablonendruck erfolgen. Dabei führt die Verwendung eines Induktionsofens oder einer UV-Durchlaufstrecke zu einer deutlichen Verkürzung der Aushärtezeit des elektrisch leitfähigen Klebstoffs sowie zu einem seriellen Ablauf der Klebung ohne Puffer oder Stack, da z.B. der Induktionsofen in einfacher Weise als Ofen mit kontinuierlichem Durchfluß von auszuhärtenden Leistungsbausteinen ausgestaltet werden kann. Die Kosten der genannten Prozesse sind gegenüber einem herkömmlichen Ofenprozeß bezüglich Energie und Anschaffung geringer, da insbesondere keine Wärmeverluste auftreten und nur die Elemente (metallische Elemente) erhitzt werden, die auch erhitzt werden sollen. Ferner ist insgesamt das Handling der Teile vereinfacht. Der Induktionsofen weist dabei eine Durchlaufstrecke mit magnetischen Spulen auf. Neben einer verkürzten Aushärtezeit wird durch Einsatz magnetischer Strahlung die Aufwärmphase des Leiterrahmens deutlich reduziert, da spezifisch metallische Teile erwärmt werden. Der in der Figur 3 dargestellte Leiterrahmen durchläuft also die Durchlaufstrecke eines Induktionsofens oder einer UV-Bestrahlungsanlage, und durch dieses Vorgehen ist eine Integration der beschriebenen Leistungsbausteinvormontage in den Fertigungsablauf der nachfolgend beschriebenen Endmontage der elektrischen Baugruppe möglich. Hierdurch ergeben sich als Einsparpontial geringere Investitionskosten (1 Ofen weniger), sowie eine Minimierung der Fertigungszeit pro Leiterrahmen als auch geringe Energiekosten.

Nach der beschriebenen Vormontage der Leistungsbausteine erfolgt die Endmontage. Dabei werden die Leistungsbausteine durch Stanzen des Leiterrahmens 20 vereinzelt und in einer Bondmontage erfolgt gegebenenfalls ein Drahtbonden, das heißt die Herstellung diverser elektrischer Verbindungen zwischen mehreren auf einem als Kupferblock 21 ausgestalteten Bodenstück 3 angeordneten Chips 4, 5. Der Leistungsbaustein 6 muß nun auf dem Kühlkörper 1 befestigt werden. Diese Verbindung wird durch einen wärmeleitenden Klebstoff realisiert. Dabei erfolgt eine Klebstoffapplikation auf dem Kühlkörper durch Stempeln, Dispensen oder Sieb- bzw. Schablonendruck. Anschließend wird der Leistungsbaustein auf die Klebstoffschicht 2 aufgebracht. In einem weiteren Schritt erfolgt eine Vorhärtung der aus einem UV-härtenden Klebstoff gebildeten Klebstoffschicht 2 in einem Randbereich um den Leistungsbaustein 6 herum, wie er in Figur 1 ersichtlich und mit Bezugszeichen 2 markiert ist. Diese Randvernetzung erfolgt durch Strahlungshärtung mit UV-Licht mit einer Wellenlänge von 10 bis 400 nm, bevorzugt bei 300 bis 400 nm, das in der Ansicht von Figur 1 von oben auf den Leistungsbaustein gerichtet wird. Dabei wird nur der besagte Randbereich der Klebstoffschicht des UV-härtbaren Klebstoffs vernetzt. Dieser Schritt dauert ca. 15 Sekunden. Diese Vorhärtung reicht aus, um die für einen nachfolgenden Drahtbondprozeß erforderliche mechanische Stabilität zu gewährleisten. In diesem Drahtbondprozeß werden die auf dem Kupferblock angeordneten Chips über Drahtbonds 9, 10, 11 bspw. durch Ultraschallschweißen elektrisch mit Kontaktierflächen 12, 13 und/oder dem Kupferblock verbunden. Als UV-härtbarer Klebstoff wird bspw. ein UV-härtbarer Acrylatklebstoff verwendet. Ein solcher UV-härtbarer Acrylatklebstoff ist bspw. unter der Markenbezeichnung Vitralit 850/7 von der Firma Panacol erhältlich. Vorteilhafterweise können hier Abstandshalter eingesetzt werden, um eine Mindestdicke der Klebstoffschicht 2 zu gewährleisten, die erforderlich ist, um mechanische Spannungen auszugleichen. In einem weiteren Schritt erfolgt ein Verguß des Leistungsbausteins und der Drahtbonds in einem Vergelprozeß. Dabei werden Leistungsbausteine sowie die Drahtbonds mit einem Gel umhüllt. Anschließend erfolgt eine Restaushärtung der Klebstoffschicht 2 unter dem Leistungsbaustein (und gegebenenfalls der Klebstoffschicht 32) und die Aushärtung des für den Vergelprozeß verwendeten Silicongels in einem Arbeitsgang in einem Ofenprozeß. Bisher wurde für die Anbindung eines Leistungsbausteins an einen Kühlkörper ein Wärmeleitklebstoff verwendet, der nur durch Wärmeeinwirkung abbindet. Dadurch mußte ein Ofenprozeß zwischen der Bestückung des Kühlkörpers mit einem Leistungsbaustein und der Drahtbondung angewendet werden, da eine mechanische Fixierung des Leistungsbausteins zur Drahtbondung notwendig ist. Im erfindungsgemäßen Verfahren hingegen werden statt 2 getrennten Ofenprozessen für Klebstoffaushärtung und Gelaushärtung, die jeweils ca. 1 ½ - 2 Stunden benötigen, nur ein gemeinsamer Ofenprozeß benötigt, wohingegen die Vorhärtung der Klebstoffschicht 2 mit einem 15 - 30 Sekunden dauernden UV Vorhärteprozeß durchgeführt wird, in dem der Randbereich der Klebstoffschicht 2 bestrahlt wird. Neben der Einsparung eines Ofenprozesses wird es möglich, den Vorhärteprozeß als Durchlaufstrecke auszugestalten, in der Baugruppen mit vorzuhärtenden Klebstoffschichen eine definierte Zeit eine von UV-Licht erfüllte Zone kontinuierlich, vom vorangegangenen Prozeßschritt ausgehend, durchlaufen, um nahtlos zum nachfolgenden Prozeßschritt des Drahtbondens zu gelangen. Da der IC Drahtgebondet wird, obwohl der Klebstoff unter dem Leistungsbaustein noch nicht ausgehärtet wurde, bezeichnet den Prozeß des Drahtbondens in diesem Verfahren auch als Naßbonden. Die Vorteile des Verfahrens der mechanischen Vorfixierung des Leistungsbausteins durch Randanhärtung des UV-härtbaren Klebstoffs liegen in einer erheblichen Kostenersparnis, da die Anschaffung eines zweiten teuren Ofens sich erübrigt und auch ungefähr die Hälfte der Energie eingespart wird, die zur Aushärtung erforderlich ist. Inbesondere vorteilhaft ist auch die 1 ½ - 2 ½ stündige Zeitersparnis, dadurch daß nur ein Ofenprozeß benötigt wird.

Der bei der Vormontage der Leistungsbausteine beschriebene Einsatz eines Induktionsofens oder eine UV-Randanhärtung eines Leitklebstoffs ist auch bei der Klebung von Chips direkt auf einem Kühlkörper denkbar, der wie in Figur 1 und 2 dargestellt, von einem Kunststoffgehäuse umgeben ist. Hier besteht der Vorteil darin, daß nur das Metall erhitzt wird, nicht aber der Kunststoff. Folglich muß nur die thermische Masse des Metalls, nicht aber des Kunststoffs erhitzt werden. Hieraus erfolgt auch eine deutliche Verkürzung der Aufwärm und damit der gesamten Aushärtezeit. Voraussetzung für den Einsatz eines Induktionsofens ist lediglich, daß einer der Klebepartner einen hohen Metallgehalt aufweist, so daß über Induktionsströme gezielt eine Aufheizung erfolgen kann. Weitere Anwendungen eines Induktionsofens könnten sein: die Montage von Leistungstransistoren und Dioden in kombinierten Löt- und Klebeprozesson, also ein sogenanntes Lötkleben oder auch die Montage von Leistungsbausteinen auf Aluminium- oder Eisenkühlkörpern.

## Patentansprüche

1. Verfahren zur Herstellung elektrischer Baugruppen (15),
- bei dem in einem ersten Schritt ein Leistungsbaustein (6) mit einem metallischen Bodenstück bereitgestellt wird,
- in einem weiteren Schritt ein Befestigungsteil (1) bereitgestellt wird,
- auf dem ein Klebstoff (2) aufgebracht und in einem weiteren Schritt das metallische Bodenstück auf dem Klebstoff (2) angeordnet wird, so daß der Klebstoff einen Randbereich um den Leistungsbaustein herum bildet,
- der Randbereich durch Bestrahlung mit UV-Licht vorgehärtet wird, wobei das UV-Licht von der Seite des Befestigungsteils (1), auf der der Klebstoff (2) aufgebracht ist, auf den Klebstoff (2) gerichtet ist,
- in einem weiteren Schritt der Leistungsbaustein mit einem Gel (33) umhüllt wird, und
- das Gel (33) und der Klebstoff (2) zusammen in einem Schritt ausgehärtet werden.

2. Verfahren nach Anspruch 1, **dadurch gekennzeichnet, daß** nach dem Vorhärten des Klebstoffs ein Drahtbonden, insbesondere ein Ultraschall-Drahtbonden, des Leistungsbausteins erfolgt.

3. Verfahren nach einem der vorhergehenden Ansprüche, **dadurch gekennzeichnet, daß** die Bereitstellung des Leistungsbausteins (6)
- die Bereitstellung eines Leiterrahmens (20) und von Chips (4, 5) umfaßt,
- wobei zwischen den Chips und dem Leiterrahmen ein Verbindungsmedium eingebracht wird,
- wobei in einem weiteren Schritt das Verbindungsmedium in einen die Chips und den Leiterrahmen zumindest teilweise verbindenden Zustand versetzt wird,
- wobei in einem weiteren Schritt eine Vereinzelung des Leistungsbausteins und gegebenenfalls ein Drahtbonden zwischen den auf dem Leistungsbaustein angeordneten Chips erfolgt.

4. Verfahren nach Anspruch 3, **dadurch gekennzeichnet, daß** als Verbindungsmedium ein weiterer Klebstoff (32) und/oder ein Lot eingesetzt wird.

5. Verfahren nach Anspruch 3 oder 4, **dadurch gekennzeichnet, daß** die Versetzung in den zumindest teilweise verbindenden Zustand durch UV-Bestrahlung oder Erhitzung in einem Induktionsofen erfolgt.

6. Verfahren nach einem der vorhergehenden Ansprüche, **dadurch gekennzeichnet, daß** als Befestigungsteil ein Kühlkörper verwendet wird.

7. Verfahren nach Anspruch 6, **dadurch gekennzeichnet, daß** der Kühlkörper mit einem Kunststoffgehäuse (31) verbunden ist.

8. Verfahren nach Anspruch 6 oder 7, **dadurch gekennzeichnet, daß** ein Deckel (30) auf dem Befestigungsteil aufgesetzt wird.

## Claims

1. Method for producing electrical assemblies (15),
- in which a power component (6) with a metallic base piece is provided in a first step,
- a fixing part (1) is provided in a further step,
- an adhesive (2) is applied on said fixing part and, in a further step, the metallic base piece is arranged on the adhesive (2), such that the adhesive forms an edge region around the power component,
- the edge region is precured by irradiation with UV light, wherein the UV light is directed onto the adhesive (2) from that side of the fixing part (1) on which the adhesive (2) is applied,
- in a further step, a power component is encapsulated with a gel (33), and
- the gel (33) and the adhesive (2) are cured together in one step.

2. Method according to Claim 1, **characterized in that** wire bonding, in particular ultrasonic wire bonding, of the power component is effected after the precuring of the adhesive.

3. Method according to any of the preceding claims, **characterized in that** providing the power component (6) comprises
- providing a leadframe (5) and chips (4, 5),
- wherein a connecting medium is introduced between the chips and the leadframe,
- wherein, in a further step, the connecting medium is put into a state of at least partially connecting the chips and the leadframe,
- wherein, in a further step, the power component is singulated and, if appropriate, wire bonding is effected between the chips arranged on the power component.

4. Method according to Claim 3, **characterized in that** a further adhesive (32) and/or a solder is used as the connecting medium.

5. Method according to Claim 3 or 4, **characterized in that** the step of putting the connecting medium into the at least partially connecting state is effected by UV irradiation or heating in an induction furnace.

6. Method according to any of the preceding claims, **characterized in that** a heat sink is used as the fixing part.

7. Method according to Claim 6, **characterized in that** the heat sink is connected to a plastic housing (31).

8. Method according to Claim 6 or 7, **characterized in that** a cover (30) is placed on the fixing part.

## Revendications

1. Procédé de fabrication d'ensembles électriques (15), selon lequel
- dans une première étape, on fournit un premier composant de puissance (6) avec une embase métallique,
- dans une autre étape, on fournit une pièce de fixation (1),
- sur cette pièce, on applique un adhésif (2) et dans une autre étape, on place l'embase métallique sur l'adhésif (2) de façon que l'adhésif forme une zone de bord autour du composant de puissance,
- on effectue un prédurcissement de la zone de bord par un rayonnement avec de la lumière ultraviolette,
- la lumière ultraviolette étant appliquée par le côté de la pièce de fixation (1) sur l'adhésif (2) pour être dirigée sur l'adhésif (2),
- dans une autre étape, on enveloppe le composant de puissance avec un gel (33), et
- on fait durcir le gel (33) et l'adhésif (2) au cours d'une étape.

2. Procédé selon la revendication 1,
**caractérisé en ce qu'**
après le prédurcissement de l'adhésif, on effectue une liaison par fils notamment une liaison par ultrason des fils du composant de puissance.

3. Procédé selon les revendications précédentes,
**caractérisé en ce que**
la fourniture du composant de puissance (6) consiste à :
- fournir un cadre conducteur (20) et des plaquettes (4, 5),
- entre les plaquettes et le cadre conducteur, on introduit un milieu de liaison,
- dans une autre étape, on met le milieu de liaison dans un état reliant au moins partiellement les plaquettes et le cadre conducteur,
- dans une autre étape, on divise le composant de puissance et le cas échéant on effectue une liaison par fils entre les plaquettes du composant de puissance.

4. Procédé selon la revendication 3,
**caractérisé en ce que**
comme milieu de liaison, on utilise un autre adhésif (32) et/ou une soudure.

5. Procédé selon la revendication 3 ou 4,
**caractérisé en ce que**
la mise dans un état de liaison au moins partiel se fait par éclairage par UV ou chauffage dans un four à induction.

6. Procédé selon les revendications précédentes,
**caractérisé en ce que**
comme pièce de fixation, on utilise un radiateur.

7. Procédé selon la revendication 6,
**caractérisé en ce qu'**
on relie le radiateur à un boîtier en matière plastique (31).

8. Procédé selon la revendication 6 ou 7
**caractérisé en ce qu'**
on applique un couvercle (30) sur la pièce de fixation.
